Europäisches Patentamt

(19) European Patent Office

Office européen des brevets

(11) Publication number: **0 016 299**
**B1**

(12) **EUROPEAN PATENT SPECIFICATION**

(45) Date of publication of patent specification: **07.08.85**

(21) Application number: **80100044.9**

(22) Date of filing: **04.01.80**

(51) Int. Cl.⁴: **G 06 F 15/20,** G 03 B 27/68,
G 03 G 15/32

(54) **System for and method of reproducing an image.**

(30) Priority: **23.03.79 US 23404**

(43) Date of publication of application:
**01.10.80 Bulletin 80/20**

(45) Publication of the grant of the patent:
**07.08.85 Bulletin 85/32**

(84) Designated Contracting States:
**AT BE CH DE FR GB IT NL SE**

(56) References cited:
**FR-A-2 213 709**
**GB-A-1 488 993**
**GB-A-1 515 052**
**GB-A-2 015 761**
**US-A-3 741 118**
**US-A-4 167 012**

(73) Proprietor: **International Business Machines
Corporation
Old Orchard Road
Armonk, N.Y. 10504 (US)**

(72) Inventor: **Shirley, Robert Edward
1133 East Lake Road
Charlotte, NC 28215 (US)**

(74) Representative: **Petersen, Richard Courtenay
IBM United Kingdom Patent Operations Hursley
Park
Winchester Hants. SO21 2JN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 016 299 B1

## Description

This invention relates to systems for and methods of reproducing an image, and seeks to provide for reproduction of an original image in a reproduced image of selected scale, which may be enlarged or reduced.

The complex nature of contemporary society has created a need for an economical means quickly to reproduce printed materials. This need has been filled by numerous copy machines with the dry paper copier foremost in the field. With the advent of these machines, there has been a widespread growth in the manipulation, transmission and recordal of image data in a wide variety of forms. For a great many applications, the extremely high resolutions achievable with photographic films and other continuous tone media are not needed and copiers of low resolution utilizing digital imaging techniques or line scanning techniques have proved to generate acceptable copy quality at a lower unit cost. In these latter systems, a line resolution of the order of 0.1 mm is generally acceptable and capable of producing photographic grey scale, half tone and line images as well as alpha-numeric characters, graphical information and the like.

It is often desirable during copying to change the size of an image by enlargement or reduction within a range of one order of magnitude and sometimes more. The means currently known for effecting such changes are not amenable to a wide range of scale variations and seldom permit precise selection of scale factors without tedious and complex adjustments. The known systems also tend to be excessively cumbersome and costly. An image may be enlarged or reduced by an optical system but normally a system capable of reduction is not readily suitable for enlargement and *vice versa*. In addition, in either type of optical system, enlargements or reductions are usually available only in a limited range due to optical considerations and when a relatively broad scale factor change is required, the optical systems become inordinately complex.

An important desirable feature for such systems is that the image recording device should be a conventional and reliable system that need not be adjusted or manipulated to give different dot sizes for different image magnification or reduction ratios. While a reduction in dot size could give higher resolution on a reduced image, the complexity and greater degree of precision necessarily required with such a system would not be desirable for the great majority of applications. Known recording techniques for producing hard copy, such as dot matrix printers, are highly reliable and operate at high rates of speed, but essentially do not permit introduction of a change in dot size. This is true whether one considers an ink jet printer, electrostatic printer, impact printer or thermal printer. One of these devices can be chosen for a given image resolution in the final copy, but what is most important in many instances is to be able immediately to obtain a reproduced image of desired size that has reasonable fidelity to the original which itself need not be of high quality.

US—A—4,090,188 discloses a dot matrix converter, and directs itself to the solution of the problem of enlarging Chinese characters. Thus the printer is arranged to enlarge a Chinese character from a dot matrix of smaller size. To this end a new row and a new column are added to the original dot matrix. However opposed bits in the rows or columns are compared with each other. As a result the new character does not exactly resemble the smaller original character. Hence, a complicated comparison between adjacent dots of the original pattern must be effected.

According to the present invention, a system for reproducing an image, comprising means for generating original image signals in the form of a train of pulses representative of intensity variations of individual pels in a pel array of rows and columns, and reproducing means under the control of said signals for generating dot patterns in rows and columns on a reproduced image medium, is characterised by means responsive to a reproduced image scale selector to generate a coded mask pulse train, comprised of a repetitive sequence of pulses of first and second values, determined by the selected scale, and means responsive to the generated image pulse train and to the coded mask pulse train to modify the image pulse train in response to mask pulses of one of the values to delete or repeat corresponding image pulses according to whether reduction or enlargement is selected, whereby to modify the numbers of rows and columns of dot patterns generated for the reproduced image from the numbers of rows and columns of pels in the original image, so that the original image is reproduced on the selected scale.

From another aspect, the present invention includes a method of reproducing an original image, comprising generating original image signals in the form of a train of pulses representative of intensity variations of individual pels in a pel array of rows amd columns by scanning the original image and, under the control of said signals, generating dot patterns in rows and columns on a reproduced image medium, characterised by generating, in response to selection of a reproduced image scale, a coded mask pulse train, comprised of a repetitive sequence of pulses of first and second values, determined by the selected scale, and combining the pulse trains to modify the image pulse train in response to mask pulses of one of the values to delete or repeat corresponding image pulses according to whether reduction or enlargement is selected, whereby to modify the numbers of rows and columns of dot patterns generated for the reproduced image from the numbers of rows and columns of pels in the original image, so that the original image is reproduced on the selected scale.

In an embodiment of the invention, a system and method are provided for transforming a image that is to be reproduced into a corresponding image by subdividing the original image into incremental picture element (pel) areas that are disposed in rows and columns. This pel data is analyzed relative to the scale factor or ratio selection of enlargement or reduction and the system then manipulates the pel data proportionally in the row and comm directions in accordance with a predetermined format determined by the scale factor. For enlargement, the pel data is manipulated by adding pel rows and columns that are duplicative of preselected or predetermined ones of the adjacent pels, and, for reduction, by deleting preselected or predetermined ones of the pel rows and columns. Whether added or deleted, the modified pel row and column data are located at positions that most closely approximate the ideal increments for the chosen scale factor.

The original image is sequentially scanned by a plurality of detector elements, which together with associated circuits divide the image into an array of a given number of pel rows and columns. Signal amplitudes representing density or opacity variations at each pel are used in digital or grey scale fashion to ultimately energize corresponding ones of a plurality of recording elements, such as ink jet recorders. However, the signal amplitudes representing individual pel variations are processed and selectively modified in accordance with both column and row positions, such that additional rows and columns are added for purposes of magnification, while the number of rows and columns are likewise reduced for purposes of image reduction.

In the modification of the image in accordance with the scale factor selected, the processor analyses the pel data of the original image relative to the number of rows or columns required for the modified image and selects that line placement which is the best approximation of the desired row or column position for each successive increment in the modified image. This selection is accomplished in part by mask creation circuitry which produces a mask utilized to control pel duplication or elimination for enlargement or reduction for image reproduction having the same number of pels per unit width length as per unit height. For example, in enlarging an image, an added row or column is inserted, in accordance with the mask, that is duplicative of either the last prior row or column or the next succeeding one, depending upon which existing row or column is the closest approximation to the desired position at a given point. The addition of either a row or a column is effected in the same format to provide an image which is proportional to the original in both the X and Y direction. In image reduction, the row or column that is deleted is the one falling between a pair of lines that are the closest approximation to the desired position. With this system, the reproduced image can be adjusted by a scale factor with a minimum of discontinuity and with fidelity generally equal to the original image in proportion and in information. Furthermore, the processing may be effected in real time either during successive individual scans of an image or by brief storage of the pel data of the original image.

The data output, after manipulation to compensate for scale factor, may now be used to control a scanning recorder or dot generator array. Such dot generators are well known the art and may for example, be exemplified by a ink jet array, a cathode ray tube display, or an electrostatic or thermal picture reproducing system.

The scope of the invention is defined by the appended claims; and how it can be carried into effect is hereinafter particularly described with reference to the accompanying drawings, in which:

Fig. 1 is a block diagram of an overall system according to the invention for producing an enlarged or reduced image of an original picture;

Fig. 2 is a function block diagram illustrating enlarging/reducing scan converter circuitry in a digital dot matrix system;

Fig. 3 is a functional block diagram illustrating mask creating circuitry useful in the system of Fig. 1;

Fig. 4 is a functional block diagram illustrating pel selection circuitry useful in the system of Fig. 1; and

Fig. 5 is a diagrammatic illustration of a pel data selection sequence in accordance with the invention.

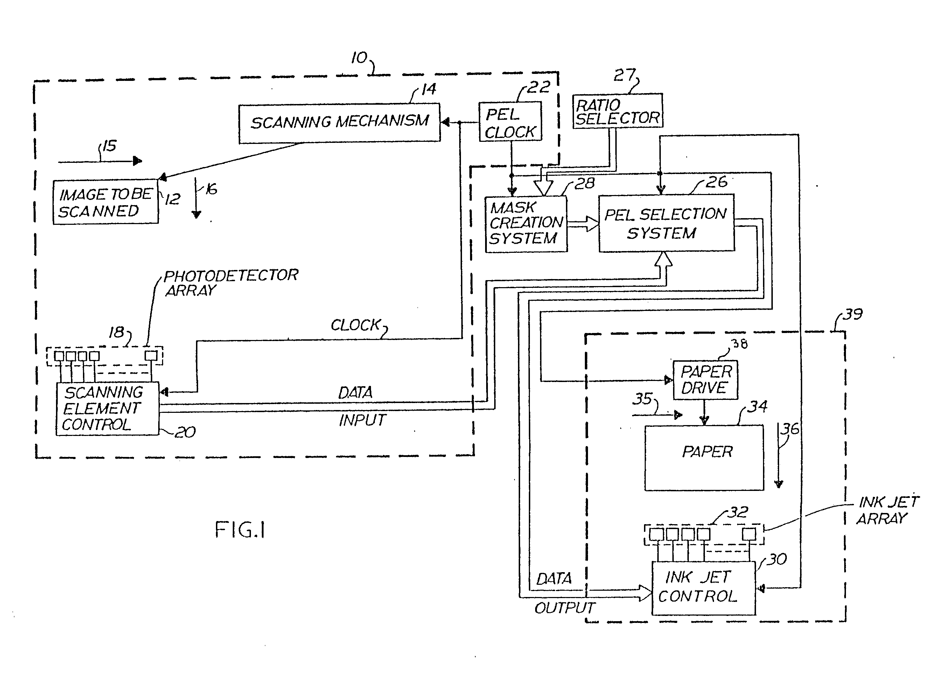

Referring now to the drawings and particularly to Fig. 1, there is illustrated in block diagram form, by way of example, a system in accordance with the invention for generating a dot data stream representing picture, alpha-numeric data, or the like for subsequent enlargement or reduction. A document scanner 10 indicates schematically the principal elements used for scanning an original document or image for producing a signal sequence representative of row and column positions on the document. The individual components with the document scanner 10 may be conventional and details thereof may therefore be omitted for the sake of clarity. The document scanner 10 generates signal amplitudes representative of intensity variations of individual picture elements (pels) in a pel array of rows and columns of the image to be scanned on a document 12. A scanning mechanism 14, depicted only generally, provides relative movement between the document 12 and a detector system in a first direction as shown by arrow 15 and in a second orthogonal direction as illustrated by arrow 16. The detector system may include, for example, an array of photo detectors 18 (only a few of which are illustrated) which are disposed such that relative motion between the document 12 and the detectors 18 results in scanning of the entire picture over a period of time. Alternatively, a single scanner element can be employed if desired, with a consequent increase in scanning time. Obviously, the relative motion can be supplied by rotating a drum or reciprocating carriage on which a document is disposed, and a part or all of the motion can be supplied by the detector array. The derivation of pel signals from the photo detectors is controlled by a scanning element control 20 which is clocked by the pel clock 22 which also synchronously controls the scanning mechanism 14.

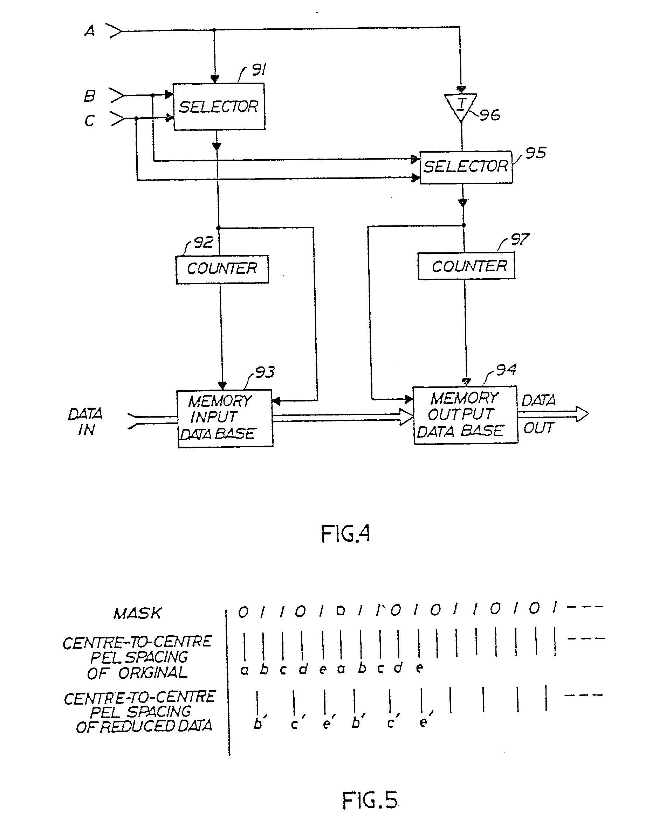

The data stream obtained from the scanning element control 20 corresponds to the intensity variations in the pels and may be provided serially for each row or column, depending on the scan direction). Each signal representative of an individual pel may have an amplitude corresponding to the grey value of the pel being scanned, or may simply be a binary signal established by a threshold detector (not shown). The signals from the scanning element control 20, identified as "data input" signals, are the input to a pel selection system 26, such as is more fully described hereinafter in connection with Fig. 4. Briefly, the pel selection system 26 may include means for storing a page or a portion of a page of the incoming data for further processing in accordance with a predetermined algorithm. The data output of the pel selection system 26 is effectively determined in part by a scale factor or image ratio selector 27 which is inputted into a mask creation system 28 coupled to the pel selection system 26 for making the determination.

By way of example, the output data from the pel selection system 26 (a number of parallel lines being energized concurrently) is coupled to an ink jet control 30 which selectively energizes elements of an array of conventional ink jet printer elements 32. The ink jet array 32 illustrated has only a relatively few elements, but it is to be understood that such an array typically includes an adequate number of ink jets for the size of documents to be reproduced. Reproduction in the instant example is effected on a paper 34 which is driven in orthogonal directions 35, 36 relative to the ink jets 32 by a suitable paper drive 38, which may be a drum of carriage device. Both the paper drive 38 and the ink jet control 30 are operated in synchronism by the pel clock 22 which clocks the entire system. Depending on the pel selection system 26 and the relationship of the scanning elements 18 and ink jets 32 the system may be operated in real time or with a delay between the input scan and output printing. For example, if the photosensitive elements and print elements can be sufficiently closely spaced for one to be used at each line, the system can operate in real time. In most instances the elements are more widely separated and an interlace technique must be employed. The image reproduction system 39 (depicted in dotted line) is conventional and other systems may be used in lieu thereof. However, such a high speed matrix printer has been disclosed, for example, in US—A 3,833,891. Such scanning recorder systems generate dot patterns in rows and columns on a medium such as paper 34 to depict the reproduced image.

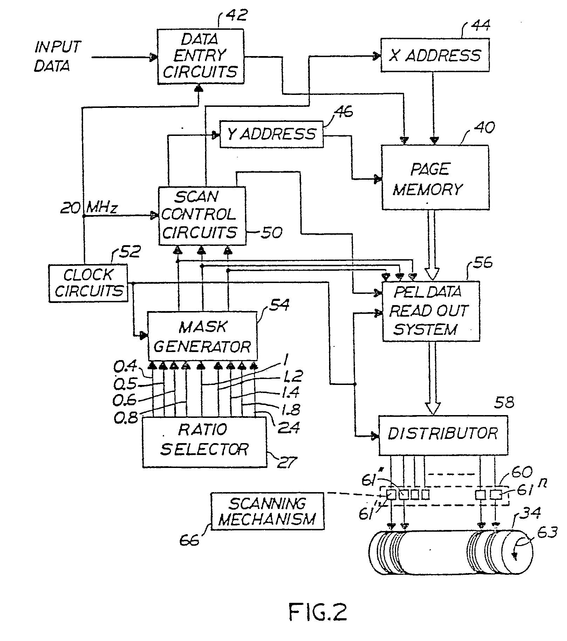

Referring now to Fig. 2, there is shown a block diagram of an enlarging/reducing scan converter subsystem which may advantageously be employed to provide ratio selection, mask creation and pel selection. This system operates in a binary digital mode, although it may alternatively provide analog levels, if desired, by use of sufficient storage capability for grey scale values. The reproducing system includes a rotating drum 63 on which the paper 34 is fastened or positioned for reproducing the enlarged or reduced image. The subsystem of Fig. 2 converts image information into binary-valued picture element (pixel) form on a dot matrix basis. The resolutions of the original and reproduced images are the same (e.g. 100 pixels per inch in this example), but this is based on the premise that the master image and the printer are to have the same pixel size. Obviously the sizes can be widely different, depending upon the nature of the reproduction to be made.

For this example, a page memory 40 is used to store a complete image of binary-valued pels, as derived from the document scanner 10 of Fig. 1. The page memory 40 may comprise any conventional digital storage means having the needed number of rows and columns, such as a semiconductor core, bubble or storage tube memory. A random access capability in both directions is not needed, inasmuch as shift registers can be used in one direction corresponding to the scan lines generated at the output printer. The scan rate of the page memory 40 system is to be adequately high to enable the printer elements to operate at optimum rate (e.g. 20 KHz) but with presently available digital memories, which have microsecond cycle times or less, this presents no practical problem.

The master image is stored, in effect, in the page memory 40 in straightforward fashion by entering the rows and columns of pels via data entry circuits 42 as X address circuits 44 and Y address circuits 46 increment the addresses in the usual fashion as determined by scan control circuits 50. Clock circuits 52 operating at a suitably high rate (e.g. 20 MHz) provide the basis for synchronization of data flow through the various circuits. While a full page memory provides a convenient example, it will be evident to those skilled in the art that, dependent upon the output printer, a lesser amount of storage may also be used. With a printing system that operates sequentially rather than in distributed fashion, only that portion of an image needed for real time operation need be stored. For example, if the output device records a single line at a time, then the storage can be similarly limited.

The data read out of the page memory 40 is fed into the pel data readout system 56, to be more fully described hereinafter in conjunction with Fig. 4. The scale factor or ratio selector 27 controls a mask generator 54 which in turn affects the scan control circuits 50 as well as the pel data readout system 56 for adding or deleting lines or columns in accordance with the reduction or enlargement ratio desired. In the example depicted, the ratio selector 27 provides four possible ratios other than unity for each function of enlargement or reduction, namely, for reduction, 0.4, 0.5, 0.6, and 0.8, and similarly for enlargement ratios 1.2, 1.4, 1.8 and 2.4 The ratios so selected are convenient examples that may be readily implemented, but as will hereinafter be discussed in detail, the ratio selection may be made on continuously variable basis, or alternatively the ratio selector 27 may provide additional increments of ratios which may vary on a regular basis or in an arbitrary fashion, as desired.

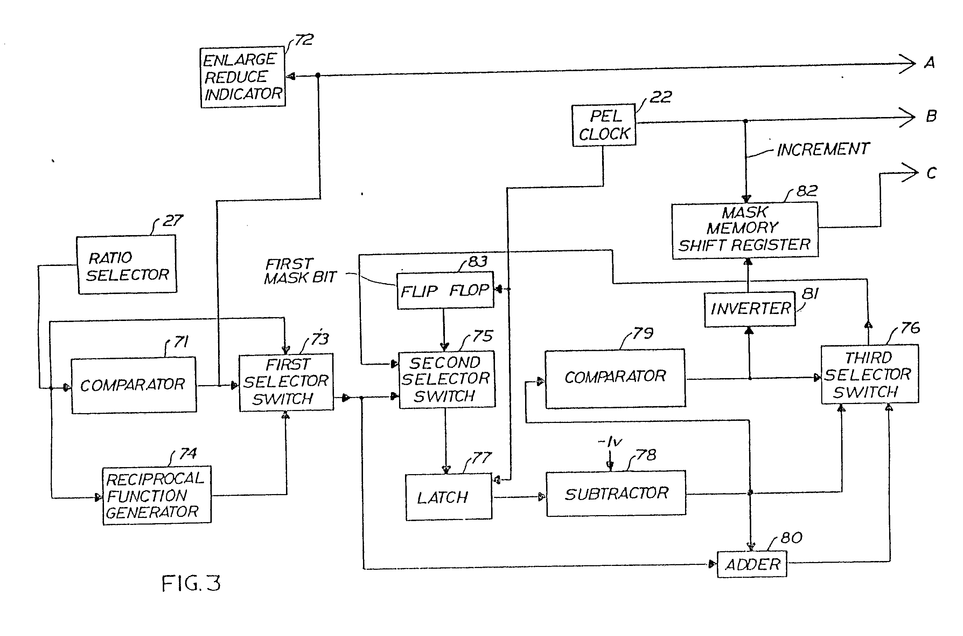

The mask generator 54 is essentially a part of the mask creation system 28 depicted in Fig. 1, an example of which will be more fully described hereinafter in accordance with the discussion of Fig. 3. With only a limited number of ratio selections available, the mask generator 54 may include, for example, a read only memory (ROM) providing repetitive signal pattern sequences to the scan control circuits 50 and to the pel data readout system 56. A greater number of discrete ratios may likewise be made available simply by using a greater number of ROMs. Alternatively dedicated circuits or a microprocessor programmed to the general mask algorithm may be used to provide an arbitrary large number of ratios. However, for most applications, there is a practical limit on the enlargements and reductions that may be generated because of the image quality attainable with a given resolution.

The outputs from the pel data readout system 56 are provided to a controller or distributor 58 for controlling a printer 60 for reproducing the image by means of a number of ink jet devices 61', 61" ... 61$^n$ equally spaced along a rotating drum 63 on which the image document or paper 34 is fastened or wrapped. A scanning mechanism 66 (e.g. carriage) provides movement of the printer jet devices 61', 61" ... 61$^n$ along the length of the drum 63 for each successive rotation. The ink jet devices are spaced so as to span the entire document 34 at some time during recording, with each device successively covering a number of scan lines. Thus, ink jet devices spaced ten scan lines apart will record in the sequence 1, 11, 21, 31, etc. on the first rotation and then 2, 12, 22, 32, etc. on the next rotation. Where the image is to be greatly reduced from the maximum available size, obviously, only one or a few of the ink jet devices 61', 61" ... 61$^n$ may be required to reproduce the image. Usually, the ink jet devices will be as closely spaced apart as permissible considering mechanical tolerances, and held at this fixed spacing. It will be evident that the printer elements may be mounted on a variable position mechanism such as a parallelogram or linkage-type device for displacement variations, which permits the spacing to be enlarged or reduced. This variation introduces an added factor in the mask generation function, and requires a precision mechanism for high resolution images in order to avoid gaps and overlaps in the reproduction.

The pel signals from the page memory 40 are suitably modified in the pel data readout system 56 to add or delete rows and columns in accordance with the ratio selected, with the output so modified being inputted to distributor 58 which may comprise a shift register for receiving individual pel commands for each of the ink jet devices, which commands are then clocked out concurrently to ensure uniform printing.

This system therefore operates by effecting changes in both columns and rows in order to enlarge or reduce the image that is being reproduced. With a square image, the numbers of columns and rows that are added or eliminated are the same. With a rectangular image the numbers are different, but the proportions automatically are held the same by mask generation. The mask that is followed may simply be repetitive in some instances, and in other instances the choice of positions at which pels are to be added or eliminated may require specific decisions. The basic algorithm to be discussed hereinafter with reference to Fig. 5 involves a determination of that position at which a given scan line or pel is closest to the ideal for a given image ratio. In scanning along a line, for example, a decision must be made as to the various points at which pels must be added during enlargement. If, in accordance with the algorithm for enlargement, the closest approximation falls between positions 75 and 76, then the pels for either positions 75 or 76 is repeated dependent upon which is closer. There is a significant difference in the overall image by following this algorithm. Instead of some purely repetitive scheme or an arbitrary rule as to approximation.

For a given ratio selection at the ratio selector 27, the mask generator 54 makes a determination for both rows (horizontal lines) and pel positions (vertical columns). No substantial demands are imposed on the mask generator 54 in doing this, because the row determination is made prior to the determination for individual columns. Using a number of ink jet heads 61', 61" ... 61$^n$, however, the mask generator 54 is required to make determinations as to which ink jet heads are to be used, and what image line each head will reproduce. If only some of the ink jet heads 61 are to be used because of the small size of a reproduced image, then the remainder will be deactivated for that image. However, the mask generator causes each ink jet head 61 that is used during scanning for a given size image to be operated during each cycle of the drum 63, in order that there is no blank scan lines during operation. The mask generator 54 then controls the scan control circuits 50, and pel data readout system 56, so as to select the next succeeding line from the page memory 40 in the event that a horizontal row is to be omitted or to cause repetition if a line is to be added. The scan control circuit 50 then controls the X and Y address circuits 44 and 46 so that the rows needed to reconstitute the image are made available at the pel data readout system 56. The distributor 58 operates routinely in distributing the serial signal from the pel data readout system 56 to the appropriate ink jet heads 61', 61" ... 61$^n$.

Thereafter, as the rows are scanned, the mask generator 54 determines which column positions are to be used. Because the ink jet heads are all in parallel relative to the vertical column positions, they all operate under mask control in the same fashion with respect to a given vertical column that is to be added or deleted.

Fig. 3 is a system block diagram of the mask creation circuitry 28 of Fig. 1. The mask produced by this circuit is utilized to control pel duplication or elimination for enlargement and reduction processes in an image reproduction system having the same number of pels per unit width as per unit height.

In Fig. 3, the scale factor or ratio selector 27 provides a means for an operator to select an enlargement or reduction ratio by setting a positive voltage representing the ratio of enlargement or reduction desired. This voltage may be selected by a continuously variable resistance means or any voltage control means providing predetermined value. The ratio selector 27 is adapted to select positive potentials greater than one for enlargement functions and positive potentials less than one for the reduction operations. The voltage selected by the ratio selector 27 is applied to comparator 72 which produces a true output whenever the input is equal to or greater than the unit value 1. Any standard comparator may be utilized to provide this function, such as the LH2, LM, or LF versions of the series 111 FET integrated circuit voltage comparators (National Semiconductor).

The output of comparator 71 is applied to the pel selection circuitry at output "A" and to an enlarge/reduce indicator 72, which in a preferred embodiment may be comprised of a pair of mutually exclusively operable indicator lamps.

Comparator 71 also controls a first selector switch 73 which may be an electronic switch such as MOS analog switch AH0014C, CF, D or CD (National Semiconductor). Selector switch 73 receives a first input in the form of an analog voltage from the ratio selector 27 and a second input also in the form of an analog voltage from ratio selector means 27 via analog reciprocal function generator 74.

The first selector switch 73 is a double-pole single-throw switching means which will pass the analog voltage selected by ratio selector 27 as a positive potential greater than 1. For instance, when a ratio or scale factor greater than 1 is selected, comparator 71 produces a true output which causes selector switch 73 to pass the output of ratio selector 27 and block the output of reciprocal function generator 74. When a reduction scale factor is selected, the output of comparator 71 is false and the first selector switch 73 blocks the potential from the ratio selector 27 but passes the reciprocal output of the ratio selector 27 produced by reciprocal function generator 74.

The output of the first selector switch 73 is applied to one input of a second selector switch 75 which is a double-pole single-throw electronic switch which may be of the same type as utilized for the first selector switch 73 to minimize hardware requirements. This switch or selector is controlled by the output of flip-flop 83 so that the input from the first selector switch 73 is passed only at the beginning of the creation of a mask when the output of the flip-flop 83 is low. The output of flip-flop 83 goes high at the creation of the first mask bit and remains high, allowing selection of the second input (i.e., the output of a third selector switch 76) of selector 75, as the following bits are generated. Flip-flop 83, which may be a SN74109 dual J—K positive-edge-triggered flip-flop with preset and clear (Texas Instruments), is reset before mask generation begins by the first pel clock pulse. The output of selector 75 is applied to latch 77 which may be a sample and hold circuit such as the integrated circuit series LF198 (National Semiconductor). The latch holds the potential passed by the second selector switch 75 for the duration of one pel. The latch is clocked by the pel clock 22, previously referred to and located in the scanning system 10 of the reproduction device. The analog potential presented by latch 77 is reduced by one unit value by subtractor 78 which may be a diode isolated summing junction having a negative one unit voltage input in addition to the input coupled to the latch 77.

The output of subtractor 78 is applied to comparator 79 which may be a circuit similar to comparator 71 except that it is adapted to provide a true output when the input is greater than one half a unit value. The output of comparator 79 controls the operation of the third selector switch 76 which is a double-throw single-pole electronic switch similar to selector switches 73 and 75. It functions to pass the output of subtractor 78 to the input of the second selector switch 75 when the output of subtractor 78 is greater than one-half a unit value (i.e. output of comparator 79 is true) and to pass the output of adder 80 to the input of the second selector switch 75 when the output of subtractor 78 is less than or equal to one-half a unit value. Adder 80 is a summing junction which combines the output of subtractor 78 and the output of the first selector switch 73 to create an analog potential which is applied to the input of the second selector switch 75 via third selector 76 when the output of comparator 79 is false.

The output of comparator 79 is applied through inverter 81 to a mask memory shift register 82. Inverter 81 may be any inverter compatible with the circuitry utilized by the system and the mask memory shift register may be any compatible serial shift register such as the integrated circuit CD4031CM or BC series (RCA). Mask memory shift register 82 is incremented by the pel clock 22 to produce a logic output "C" to the pel selection circuitry which is a function of the selected scale factor. For instance, assuming a scale factor of 2 is selected, an analog voltage having a two unit value is produced by the ratio selector 27. Since this potential is greater than a single unit value, comparator 71 provides a true output which causes the first selector switch 73 to pass the positive two unit value to its output. The two unit value analog potential is applied through the second selector switch 75, because the output of the flip-flop 83 is low at this time and causes latch 77 to reach a two unit value. This value is clocked by the pel clock through subtractor 78 and the resultant analog potential of one unit is applied to comparator 79. This causes a true output of the comparator 79 and the true output causes the the third selector switch 76 to couple the one unit analog potential output of subtractor 78 to the alternate input of the second selector switch 75. This causes selector 75 to inhibit passage of the input from selector 73 and pass the input from the third selector switch 76 to latch 77. The output of selector 76 is one unit value and thus the input to subtractor 78 at the next pel clock will be one unit value. This causes a zero output and the output of comparator 79 is false. Selector 76 then switches and inhibits passage of the output of subtractor 78 and couples the output of adder 80 to selector 75. At this time the output of adder unit 80 is the two unit potential constantly being passed by selector 73 and the zero potential output of subtractor 78. The resultant two unit value is passed through the first selector switch 73 and the cycle is repeated. As this cycle is repeated, the output of comparator 79 goes from "1" to "0" or true to false and this through the inverter 81 creates an electronic mask comprising a 0101 repetitive input to shift register 82 which produces an electronic mask comprising a repetitive 1010 pulse train.

In accordance with the electronic mask, with a scale factor of 2, that is greater than unity, the enlarge/reduce indicator 72, so indicates and the algorithm views the pulse train as a series of commands for each pel of the original image with a "1" in the pulse train effectively instructing the printer to reproduce a pel from the original image with the "0" in the pulse train instructing the printer to duplicate the last pel.

By way of another example which will be amplified hereinafter with reference to Fig. 5, if the scale factor selected is 5/3, the repetitive pulse train will be 110101101011010, etc. Correspondingly, for this enlargement scale factor, the print instructions in both the column and row direction will be identical with each "1" effectively instructing the printer to print that corresponding pel of the original image, and each "0" effectively instructing the printer to duplicate the immediately preceding pel row or column.

Conversely, if reduction is indicated at indicator 72, the repetitive pulse train for the inverse scale factor of 5/3 will be identical. That is, for a scale factor of 3/5, the repetitive pulse train will be 11010110101101, etc., with each "1" in the train effectively instructing the system to print in the reduced image the pel corresponding to the original image with each "0" instructing the system to eliminate that pel row or column of the original image at that location with the gap on the reproduced reduced image being closed by means of the pel data readout system 56.

Similarly, if a scale factor of 1/2 were selected the system would function in an identical manner to that described with reference to a scale factor of 2, except that the positive 2 unit value potential present at the output of selector 73 would be derived via reciprocal function generator 74 rather than directly from the ratio selector 27. If a scale factor of 3 were selected, the sequential output of comparator 79 would be 110110110, etc. and this would be repeated for the duration of the electronic mask as a repetitive 001 code.

The electronic mask output C of the mask memory serial shift register 82 of Fig. 3 is applied to one input of selector 91 of the pel data readout system 56, more fully shown in Fig. 4 and the output B from pel clock 22 is connected to another input of selector 91. This selector forms part of the pel selection system 26 of Fig. 1. It is a double-pole single-throw switch which in a preferred embodiment is an electronic switch similar to selector switches 73 and 76 of Fig. 3. Selector 91 is responsive to control function output A from comparator 71 of Fig. 3. This control input from the comparator is true if an enlarge function has been selected wherein the output is equal to or greater than 1 and false when the output of the comparator is zero. If an enlarge function was selected, the input from the mask memory serial shift register 82 of Fig. 3 will be coupled through selector 91 to counter 92.

Counter 92 is an increment counter such as the integrated circuit type DM75/8570 or DM76/86L70 (National Semiconductor) or two 4-bit binary counters SN74163 (Texas Instruments). In a preferred example the counter is a 8 bit shift register which features a gated serial input and an asynchronous clear. The output of counter 92 addresses memory input data base 93 which receives data in its entirety from the page memory 40. The memory 93 may be any one of a large variety of memory register devices but in a preferred embodiment is an integrated circuit such as MM74C200 (National Semiconductor) which is a 256 bit tri-state random access read/write memory having an input capable of accepting 8 address lines and a write enable line. Counter 92 addresses a single memory site for each "1" pulse of the electronic mask.

In analogous manner, the mask output C is applied to one input of selector 95, which is similar to the selector 92, and the output B from the pel clock 22 to another input of selector 95. The selector 95 is responsive to the inverse of the control function output A from comparator 71 of Fig. 3, which output is connected through inverter 96 to the selector 95. If a reduction function is selected, the input from register 82 of Fig. 3 will be coupled through selector 95 to counter 97.

Counter 97 is similar to counter 92 and addresses memory output data base 94 which is similar to memory 93.

In enlargement mode, selector 91 selects the mask output C, and selector 95 selects the pel clock output B. The mask pulse train and pel clock are synchronized. The output of selector 91 is connected to counter 92 and memory 93, so that each time a "1" appears on the mask, the address of memory 93 is incremented and the contents of this next successive address are read out and transferred to the input of memory output data base 94 where it is held until the next "1" in the mask. The output of selector 95 is connected to counter 97 and memory 94, so that the address of memory 94 is incremented and another pel is read into memory 94 on every period of the pel clock. For enlargement, these pels are new pels when the mask is a "1" but are duplicates of the last pel when the mask is a "0".

In reduction mode, selector 91 selects the pel clock output B, and selector 95 selects the mask output C. So, a pel is read out of memory 93 on every period of the pel clock but is only read into memory 94 when the mask is a "1". When the mask is a "0" memory 94 is idle and therefore this pel is discarded from the output data base.

The output of memory output data base 94 is the image signal which is applied to each picture element in the dot matrix during image generation. That is, if an enlargement function similar to that previously described having an electronic mask function code of 101010 or an enlargement function of 2 were selected, the output of memory output data base 94 would be two identical pel outputs for each alternate pel input to memory input data base 93. The output of memory 94 would also cause the scan or row functions to be duplicated so that in addition to each column of pels being reproduced a second time to duplicate the input, each row or scan would be duplicated so that the final image generation would be twice the size of the original.

In the event that a reduction function were selected, memory output data base 94 would function in a manner identical to that required for enlargement functions except its output would be reducing the row and column pel structure by a factor equal to the code generated by the mask memory serial shift register 82.

In order to visualize the mask algorithm, by reference to Fig. 5, there is diagrammatically depicted in horizontal rows the "mask" repetitive pulse train, with the next horizontal row comprising a series of vertical lines, equally spaced to indicate the centre-to-centre pel spacing of the original image, with the next horizontal row of vertical lines being likewise equally spaced to depict the centre-to-centre pel spacing of reduced data when a scale factor of 3/5 is selected, that is, a reduction ratio. By visualizing the reduced data base as a pel selection from the original data base on the premise that the centre-to-centre pel spacing of the reduced data base is constant and of a greater centre-to-centre distance than the original base, the algorithm selects the pel from the original image nearest the pel for the reduced image with the remainder of the original pels being discarded, and consequently not printed for the reduced image. The vertical lines depicting the pel spacing of the original are designated a, b, c, d, and e, which then repeats itself in accordance with the mask 01101. With a scale factor of 3/5, only three of the original pels are reproduced, the three pels so reproduced being depicted in the bottom row with the designations b', c' and e', effectively correlating to the reproduction of original pels b, c, and e which, as can be seen, are in vertical alignment with the "1" of the mask with the original pels in vertical alignment with the "0" of the mask being discarded for reduction purposes. It is to be understood, that the depiction in Fig. 5 is diagrammatic for the purpose of defining an explaining the creation of the algorithm to be followed by a system in accordance with the invention, with the ultimate printing of the pels correlated to b', c' and e' being spaced relative to each other with the same resolution as the original image resulting in both the row and column size of the reduced image being 3/5ths that of the original image. In the illustration of Fig. 5, the first vertical line designated b' in the lower horizontal row is nearer the "b" pel line of the original than to the "a" pel line resulting in the "a" pel line of the original being discarded and the "b" pel line of the original being reproduced. Similarly, the second vertical line of reduced data designated c' is closer in spacing to the "c" pel line of the original data than to the "d" pel line of the original resulting in the "c" pel being reproduced as c' with the "d" pel line of the original being discarded. In enlargement, the algorithm treatment is simply a corollary to reduction.

The mask created in accordance with the invention has the property of being able to create any scale factor while creating the smoothest possible scaling by duplicating and/or discarding the smallest number of contiguous pels necessary for creation of the so-called data base.

The algorithm so derived produces a predetermined format for pel selection of the data of the page memory 40 via the pel data readout system 56 for selectively printing predetermined ones of the original pel data rows and columns with the selection of predetermined ones of the original image pels for duplication or deletion, with the predetermined format being applied in both the row and column direction to maintain proportionality in the scaled image utilizing the same dot sizes for providing the closest approximation to the ideal.

While there has been shown and described a preferred embodiment, it is to be understood that various other adaptations and modifications may be made within the scope of the invention.

**Claims**

1. A system for reproducing an image, comprising means (10) for generating original image signals in the form of a train of pulses representative of intensity variations of individual pels in a pel array or rows and columns, and reproducing means (39) under the control of said signals for generating dot patterns in rows and columns on a reproduced image medium, characterised by means (28) responsive to a reproduced image scale selector (27) to generate a coded mask pulse train, comprised of a repetitive sequence of pulses of first and second values, determined by the selected scale, and means (26) responsive to the generated image pulse train and to the coded mask pulse train to modify the image pulse train in response to mask pulses of one of the values to delete or repeat corresponding image pulses according to whether reduction or enlargement is selected, whereby to modify the numbers of rows and columns of dot patterns generated for the reproduced image from the numbers of rows and columns of pels in the original image, so that the original image is reproduced on the selected scale.

2. A system according to claim 1, in which the reproduced image scale is selectible by incremental amounts.

3. A system according to claim 2, in which, for image enlargement the rows and columns of dots selected for repetition are those closest to the individual fractional positions needed for the desired scale reproduction.

4. A system according to claim 2, in which, for image reduction, the rows and columns of dots not selected for deletion are those closest to the individual fractional positions needed for the desired scale reproduction.

5. A system according to claim 1, 2, 3 or 4, in which the train of coded mask pulses is synchronised with the image signal train.

6. A system according to claim 5, including memory means (93) for storing picture element signals in discrete, addressable memory locations as a functions of the coded mask pulse train.

7. A system according to claim 6, comprising scale factor selection means (27) for selectively generating an enlarge function or a reduction function and coupled to control means (28) for the generation of the coded mask pulse train, picture element clocking means (22), and addressing means (95, 97) responsive to the coded mask pulse train, the picture element clocking means, and the picture element signal sequence for entering picture element signals in successive addresses of the memory means.

8. A system according to claim 7, in which, when the system operates to perform an enlarge function, the individual signals representing the picture elements are selectively repeated in successive positions in the memory means in response to the coded mask pulse train.

9. A system according to claim 7 or 8, in which when the system operates to perform the reduction function, individual signals representing the picture elements are selectively deleted during entry of signals into the memory means in response to the coded mask pulse train.

10. A system according to claim 5, 6, 7, 8 or 9, including a shift register (82) coupled to receive pulses from a coded mask pulse train generator, which pulses are generated in response to a scale factor selector coupled to the generator.

11. A system according to claim 10, in which the scale factor selector comprises means to select a voltage level, comparator means (71) for determining the outcome of a comparison of the selected voltage level with respect to a reference voltage level, means (74) to take the reciprocal of the selected voltage level, and switch means (73) responsive to the comparator for mutually exclusively coupling the selected voltage level or the reciprocal of the selected voltage level to the pulse generator.

12. A system according to claim 10, in which the pulse generator comprises first switch means (75), sample and hold means (77) to store the voltage level at the output of the first switch means, subtractor means (78) for subtracting a reference voltage from the voltage level in the sample and hold means, unity determining means (79) for determining when the output of the subtractor means is greater than one half of the reference voltage, summing means (80) for adding the output of the scale factor selector and the subtractor means, second switch means (76) responsive to the unity determining means for mutually exclusively coupling the output of the subtractor means or the summing means to the first switch means, the first switch means being responsive to the output of the second switch means for mutually exclusively coupling the output of the second switch means or the scale factor selector to the sample and hold means, and means (81) to couple the output of the unity determining means to the shift register (82).

13. A system according to any preceding claim, including means (18) for scanning an original image to generate the original image signals.

14. A method of reproducing an original image, comprising generating original image signals in the form of a train of pulses representative of intensity variations of individual pels in a pel array of rows and columns by scanning the original image, and under the control of said signals, generating dot patterns in rows and columns on a reproduced image medium, characterised by generating, in response to selection of a reproduced image scale, a coded mask pulse train, comprised of a repetitive sequence of pulses of first and second values, determined by the selected scale, and combining the pulse trains to modify the image pulse train in response to mask pulses of one of the values to delete or repeat corresponding image pulses according to whether reduction or enlargement is selected, whereby to modify the numbers of rows and columns of dot patterns generated for the reproduced image from the numbers of rows and columns of pels in the original image, so that the original image is reproduced on the selected scale.

**Patentansprüche**

1. System zum Reproduzieren eines Bildes, mit Mitteln (10) zur Erzeugung von dem originalen Bild entsprechenden Signalen in der Form einer Folge von Impulsen, die die wechselnde Intensität der einzelnen Bildelemente in einer Bildelemente-Anordnung oder in Bildelemente-Zeilen oder -Spalten darstellen; mit von den Signalen gesteuerten Reproduzier-Mitteln (39) zur Erzeugung von Punktmustern in Zeilen und Spalten auf einem Abbildungsmedium, durch Mittel (28), die im Ansprechen auf einen Skalen-Selektor des reproduzierten Bildes (27) eine Folge von kodierten Maskenpulsen erzeugen, aus einer wiederholten Sequenz von Impulsen für erste oder zweite Werte bestehend, die von der ausgewählten Skala bestimmt sind, und durch Mittel (26) gekennzeichnet, die im Ansprechen auf die Folge von den erzeugten Bildpulsen und auf die Folge von kodierten Maskenpulsen die Folge der Bildpulsen im Ansprechen auf die Maskenpulsen für einen der Werte zum Löschen oder zur Wiederholung der entsprechenden Bildpulsen in Abhängigkeit davon verändern, dass die Verkleinerung oder der Vergrösserung des Abbildes gewählt ist, wodurch die Anzahl der Zeilen und Spalten der Punktmuster verändert ist, die für das reproduzierte Bild ab der dem originalen Bild entsprechenden Anzahl der Bildelemente-Zeilen und -Spalten erzeugt wurden, so dass das originale Bild auf der ausgewählten Skala reproduziert ist.

2. System nach Anspruch 1, in dem die Skala des reproduzierten Bildes von inkrementalen Beträgen ansteuerbar ist.

3. System nach Anspruch 2, in dem bezüglich der Bildvergrösserung die zur Wiederholung ausgewählten Zeilen und Spalten von Punkten diejenigen sind, die am nächsten der einzelnen für die erwünschte Skalenreproduktion erforderlichen Bruchteil-Positionen liegen.

4. System nach Anspruch 2, in dem bezüglich der Bildverkleinerung die Zeilen und Spalten von Punkten, die für das Löschen nicht ausgewählt sind, diejenigen sind, die am nächsten der einzelnen für die erwünschte Skalenreproduktion erforderlichen Bruchteil-Positionen liegen.

5. System nach Anspruch 1, 2, 3 oder 4, in dem die Folge der kodierten Maskenpulsen mit der Folge der Bildsignalen synchronisiert ist.

6. System nach Anspruch 5 mit Speichermitteln (94) zur Speicherung der Bildelemente-Signale in einzelnen adressierbaren Speicherstellen als eine Funktion der Folge der kodierten Maskenpulsen.

7. System nach Anspruch 6 mit Auswahlmitteln (27) des Skalenexponenten zur Erstellung wahlweise einer Vergrösserungs- oder Verkleinerungs-Funktion, wo diese Mittel mit Steuermitteln (28) zur Erzeugung der Folge von kodierten Maskenpulsen, mit Taktgebermitteln (22) für die Bildelemente, und mit Adressierungsmitteln (95, 97) verbunden sind, die von der Folge der kodierten Maskenpulsen, den Bildelemente-Taktgebermitteln und von der Signalsequenz der Bildelemente zur Aufzeichnung der Bildelemente-Signale in den aufeinderfolgenden Adressen der Speichermittel ansteuerbar sind.

8. System nach Anspruch 7, in dem beim Betrieb des Systems zur Ausführung einer Vergrösserungs-Funktion die einzelnen die Bildelemente darstellenden Signale in aufeinanderfolgenden Stellen der Speichermittel im Ansprechen auf die Folge der kodierten Maskenpulsen wahlweise wiederholt sind.

9. System nach Anspruch 7 oder 8, in dem beim Betrieb des Systems zur Ausführung einer Verkleinerungs-Funktion einzelne die Bildelemente darstellende Signale während der Aufzeichnung der Signale in der Speichermitteln im Ansprechen auf die Folge der kodierten Maskenpulsen wahlweise im Wegfall gebracht sind.

10. System nach Anspruch 5, 6, 7, 8 oder 9, mit einem Verschieberegister (82), das zur Aufnahme der Impulsen aus einem Generator für die Folge der kodierten Maskenpulsen gekoppelt ist, wo diese Impulsen im Ansprechen auf einen mit dem Generator verbundenen Skalenexponent-Selektor erzeugt sind.

11. System nach Anspruch 10, in dem der Selektor des Skalenexponenten Mittel Zur Auswahl eines Spannungswertes, Vergleichsmittel (71) zur Bestimmung des Vergleichsergebnisses des ausgewählten Spannungswertes mit einem Referenz-Spannungswert, Mittel (74) zur Aufnahme des Reciprokwertes des ausgewählten Spannungswertes, und Schaltmittel (73) aufweist, die im Ansprechen auf die Vergleichsmittel den ausgewählten Spannungswert oder den Reziprokwert des ausgewählten Spannungswertes mit dem Impulsgenerator gegenseitig ausschliessend koppeln.

12. System nach Anspruch 10, in dem der Impulsgenerator erste Schaltmittel (75), Abfrageund Speichermittel (77) zur Speicherung des Spannungswertes am dessen Ausgang aus den ersten Schaltmitteln, Subtrahmittel (78) zum Subtrahieren eines Referenz-Spannungswertes von den Spannungswert in den Abfrage- und Speichermitteln, Einheit-Erkennungsmittel (79) zur Festlegung, wenn die Ausgabe der Subtrahiermittel grösser als die Hälfte des Referenz-Spannungswertes ist, Addiermittel (80) zum Addieren der Ausgabe des Skalenexponent-Selektors zu den Subtrahiermitteln, zweite Schaltmittel (76), die im Ansprechen auf die Einheit-Erkennungsmittel die Ausgabe der Subtrahiermittel oder der Addiermittel mit den ersten Schaltmitteln gegenseitig ausschliessend koppeln, wobei die ersten Schaltmittel im Ansprechen auf die Ausgabe der zweiten Schaltmittel die Ausgabe der zweiten Schaltmittel oder des Skalenexponent-Selektors mit den Abfrage- und Speichermitteln gegenseitig ausschliessend koppeln, und Mittel (81) zur Kopplung der Ausgabe der Einheit-Erkennungsmittel mit dem Verschieberegister (82) einschliesst.

13. System nach einem der vorhergehenden Ansprüche mit Mitteln (18) zum Abtasten des originalen Bildes zur Erzeugung von dem originalen Bild entsprechenden Signalen.

14. Verfahren zum Reproduzieren eines originalen Bildes, einschliesslich die Erzeugung von dem orignalen Bild entsprechenden Signalen in der Form einer Folge von die wechselnde Intensität der einzelnen Bildelemente in einer Bildelemente-Anordnung von Zeilen und Spalten darstellenden Impulsen durch Abtasten des originalen Bildes, und, unter Steuerung dieser Signale, die Erzeugung von Punktmustern in Zeilen und Spalten auf einem Abbildungsmedium, wo das Verfahren durch die Erzeugung einer Folge von kodierten Maskenpulsen, aus einer wiederholten Sequenz von Impulsen für erste und zweite Werte bestehend, die von der ausgewählten Skala bestimmt sind, im Ansprechen auf die Auswahl einer Reproduktions-Skala gekennzeichnet, ist und auch durch die Zusammenfassung der Impulsfolgen zur Veränderung der dem Bild entsprechenden Folge von Bildpulsen im Ansprechen auf die Maskenpulsen für einen der Werte zum Löschen oder zur Wiederholung der entsprechenden Bildpulsen, im Abhängigkeit davon, dass die Verkleinerung oder die Vergrösserung gewählt ist, wodurch die Anzahl von Zeilen und Spalten der Punktmuster verändert ist, die für das reproduzierte Bild ab der dem originalen Bild entsprechenden Anzahl der Bildelemente-Zeilen und -Spalten erzeugt wurden, so dass das originale Bild auf der ausgewählten Skala reproduziert ist.

## Revendications

1. Un système pour reproduire une image comprenant des moyens (10) pour générer des signaux d'image originale sous la forme d'un train d'impulsions représentatif de variations d'intensité d'éléments pel individuels dans un réseau ou des rangées et colonnes d'éléments pel, et des moyens de reproduction (39) sous la commande desdits signaux pour générer des configurations de points en rangées et un colonnes sur un milieu d'image.reproduite, caractérisé par des moyens (28) répondant à une sélecteur d'échelle d'image reproduite (27) pour générer un train d'impulsions de masque codées formé d'une séquence répétitive d'impulsions de première et seconde valeurs, déterminé par l'échelle sélectionnée et des moyens (26) répondant au train d'impulsions d'image généré et au train d'impulsions de masque codées pour modifier le train d'impulsions d'image en réponse à des impulsions de masque de l'une des valeurs pour supprimer ou répéter des impulsions d'image correspondantes selon que une réduction ou un agrandissement a été sélectionné et modifier ainsi le nombre des rangées et des colonnes de configurations des points générées pour l'image reproduite à partir du nombre des rangèes et des colonnes d'éléments pel dans l'image originale si bien que l'image originale est reproduite sur l'échelle sélectionnée.

2. Un système selon la revendication 1, dans lequel l'échelle de l'image reproduite peut être sélectionnée par incréments.

3. Un système selon la revendication 2, dans lequel pour l'agrandissement de l'image, les rangées et les colonnes de points sélectionnées pour répétition sont celles les plus proches des positions fractionnelles individuelles nécessaires pour la reproduction à l'échelle désirée.

4. Un système selon la revendication 2, dans lequel pour la réduction de l'image, les rangées et les colonnes de points non sélectionnées pour suppression sont celles les plus proches des positions fractionnelles individuelles nécessaires pour la reproduction à l'échelle désirée.

5. Un système selon la revendication 1, 2, 3 ou 4, dans lequel le train d'impulsions de masque codées est synchronisé avec le train de signaux d'image.

6. Un système selon la revendication 5, comprenant des moyens à mémoire (94) pour emmagasiner des signaux d'éléments image dans des positions discrètes et adressables de mémoire en fonction du train d'impulsions de masque codées.

7. Un système selon la revendication 6, comprenant des moyens de sélection de facteur d'échelle (27) pour générer sélectivement une fonction d'agrandissement ou une fonction de réduction et accouplés aux moyens de commande (28) pour générer le train d'impulsions de masque codées, des moyens de synchronisation d'éléments image (22) et des moyens d'adressage (95, 97) répondant au train d'impulsions de masque codées, les moyens de synchronisation d'éléments image et la séquence de signaux d'éléments image pour placer des signaux d'éléments image à des adresses successives des moyens à mémoire.

8. Un système selon la revendication 7, dans lequel, lorsque le système fonctionne pour assurer une fonction d'agrandissement, les signaux individuels représentant les éléments image sont sélectivement répétés dans des positions successives des moyens à mémoire en réponse au train d'impulsions de masque codées.

9. Un système selon la revendication 7 ou 8, dans lequel, lorsque le système fonctionne pour assurer la fonction de réduction, des signaux individuels représentant les éléments image sont sélectivement supprimés pendant l'entrée des signaux dans les moyens à mémoire en réponse au train d'impulsions de masque codées.

10. Un système la revendication 5, 6, 7, 8 ou 9, comprenant un registre à décalage (82) accouplé pour recevoir des impulsions d'un générateur de train d'impulsions de masque codées, lesquelles impulsions sont générées en réponse à une sélecteur de facteur d'échelle accouplé au générateur.

11. Un système selon la revendication 10, dans lequel le sélecteur de facteur d'échelle comprend des moyens pour sélectionner un niveau de tension, des moyens de comparaison (71) pour déterminer le résultat d'une comparaison du niveau de tension sélectionné par rapport à un niveau de tension de référence, des moyens (74) pour prendre la réciproque du niveau de tension sélectionné et des moyens de commutation (73) répondant au comparateur pour accoupler de manière mutuellement exclusive le niveau de tension sélectionné ou la réciproque du niveau de tension sélectionné au générateur d'impulsions.

12. Un système selon la revendication 10, dans lequel le générateur d'impulsions comprend des premiers moyens de commutation (75), des moyens d'échantillonnage et de maintien (77) pour emmagasiner le niveau de tension à la sortie des premiers moyens de commutation, des moyens de soustraction (78) pour soustraire une tension de référence du niveau de tension dans les moyens d'échantillonnage et de maintien, des moyens de détermination d'unité (79) pour indiquer quand la sortie des moyens de soustraction est supérieure à la moitié de la tension de référence, des moyens de sommation (80) pour additionner la sortie du sélecteur de facteur d'échelle et des moyens de soustraction, des seconds moyens de commutation (76) répondant aux moyens de détermination d'unité pour accoupler de manière mutuellement exclusive la sortie des moyens de soustraction ou des moyens de sommation aux premiers moyens de commutation, les premiers moyens de commutation étant sensibles à la sortie des seconds moyens de commutation pour accoupler de manière mutuellement exclusive la sortie des seconds moyens de commutation ou du sélecteur de facteur d'échelle aux moyens d'échantillonnage et de maintien et des moyens (81) pour accoupler la sortie de moyens de détermination d'unité au registre de décalage (82).

13. Un système selon l'une quelconque des revendications précédentes, comprenant des moyens (18) pour balayer une image originale afin de générer des signaux d'image originale.

14. Une méthode de reproduction d'une image originale comprenant la génération de signaux d'image originaux sous la forme d'un train d'impulsions représentant des variations d'intensité d'éléments pel individuels dans un réseau d'éléments pel en rangées et colonnes par le balayage de l'image originale et, sous la commande desdits signaux, la génération de configurations de points en rangées et colonnes sur un milieu d'image reproduite, caractérisée par la génération, en réponse à la sélection d'un échelle d'image reproduite, d'un train d'impulsions de masque codées formé d'une séquence répétitive d'impulsions de premiere et seconde valeurs déterminé par l'échelle sélectionnée, et la combinaison des trains d'impulsions pour modifier le train d'impulsions d'image en réponse aux impulsions de masque de l'une des valeurs pour supprimer ou répéter des impulsions d'image correspondantes selon que la réduction ou l'agrandissement est sélectionné, ce qui permet de modifier le nombre de rangées et de colonnes de configurations de point générées pour l'image reproduite à partir du nombre de rangées et de colonnes d'éléments pel dans l'image originale, si bien que l'image originale est reproduite à l'échelle sélectionnée.

FIG.1

0 016 299

FIG.2

FIG. 3

0 016 299

FIG.4

FIG.5

4